# EUROPÄISCHE PATENTSCHRIFT

(11) **EP 3 848 864 B1**
(45) Veröffentlichungstag und Bekanntmachung des Hinweises auf die Patenterteilung: **17.01.2024**
(21) Anmeldenummer: 20201678.8
(22) Anmeldetag: 14.10.2020
(51) Int. Cl.: B22F 10/12, B22F 10/73, B22F 12/00, B29C 64/124, B29C 64/165, B29C 64/194, B29C 64/236, B29C 64/245, B29C 64/35, B29C 64/357, B33Y 10/00, B33Y 30/00, B33Y 40/00, B33Y 70/10, B33Y 80/00, G06Q 10/20

(54) **VERFAHREN ZUR BEURTEILUNG VON AUSWIRKUNGEN VON ÄNDERUNGEN**
METHOD FOR EVALUATING EFFECTS OF CHANGES
PROCÉDÉS D'ÉVALUATION DES EFFETS DES CHANGEMENTS

(30) Priorität: 13.01.2020 AT 500142020
(43) Veröffentlichungstag der Anmeldung: 14.07.2021
(73) Patentinhaber: Uptime Holding GmbH, 8010 Graz (AT)
(72) Erfinder: Langmayr, Franz, 8020 Graz (AT)
(74) Vertreter: Wirnsberger & Lerchbaum Patentanwälte OG

(56) Entgegenhaltungen:
- DINTZNER NICOLAS ET AL: "Evaluating Feature Change Impact on Multi-product Line Configurations Using Partial Information", 4. Januar 2015 (2015-01-04), BIG DATA ANALYTICS IN THE SOCIAL AND UBIQUITOUS CONTEXT : 5TH INTERNATIONAL WORKSHOP ON MODELING SOCIAL MEDIA, MSM 2014, 5TH INTERNATIONAL WORKSHOP ON MINING UBIQUITOUS AND SOCIAL ENVIRONMENTS, MUSE 2014 AND FIRST INTERNATIONAL WORKSHOP ON MACHINE LE, XP047303694, ISBN: 978-3-642-17318-9 * das ganze Dokument *
- DONG XU ET AL: "Simulation-based assessment of change propagation effect in an aircraft design process", 20111211; 1077952576 - 1077952576, 11. Dezember 2011 (2011-12-11), Seiten 1715-1726, XP058028861, DOI: 10.1109/WSC.2011.6147887
- HAN AH-RIM ET AL: "Dynamic profiling-based approach to identifying cost-effective refactorings", INFORMATION AND SOFTWARE TECHNOLOGY, ELSEVIER, AMSTERDAM, NL, Bd. 55, Nr. 6, 20. Dezember 2012 (2012-12-20), Seiten 966-985, XP028581135, ISSN: 0950-5849, DOI: 10.1016/J.INFSOF.2012.12.002
- YULIANG LI ET AL: "A process simulation based method for scheduling product design change propagation", ADVANCED ENGINEERING INFORMATICS, ELSEVIER, AMSTERDAM, NL, Bd. 26, Nr. 3, 16. April 2012 (2012-04-16) , Seiten 529-538, XP028404557, ISSN: 1474-0346, DOI: 10.1016/J.AEI.2012.04.006 [gefunden am 2012-05-03]
- YEASIN FATMA NUR ET AL: "A Bayesian Networks Approach to Estimate Engineering Change Propagation Risk and Duration", IEEE TRANSACTIONS ON ENGINEERING MANAGEMENT, IEEE, USA, vol. 67, no. 3, 23 January 2019 (2019-01-23), pages 869-884, XP011798997, ISSN: 0018-9391, DOI: 10.1109/TEM.2018.2884242 [retrieved on 2020-07-16]

## Beschreibung

Die Erfindung betrifft ein Verfahren zur Beurteilung von Auswirkungen von zumindest einer Änderung auf ein mehrere, insbesondere zumindest drei, Komponentengruppen, welche jeweils eine oder mehrere Komponenten aufweisen, aufweisendes Produkt.

Es ist bekannt, dass Produkte, insbesondere mechatronische Produkte, wie beispielsweise Fahrzeuge, Motore oder Anlagen während einer Lebenszeit Änderungen unterworfen sind. So wird häufig während der Lebenszeit eines Produktes, insbesondere bei Massenprodukten oder Serienprodukten, geprüft, ob und gegebenenfalls an welchen Komponenten Einsparungen möglich sind, beispielsweise durch einen Austausch eines Bauteils aus einem teuren Material gegen ein Bauteil aus einem kostengünstigeren Material. Dies führt allerdings häufig zu Problemen bei einer Zuverlässigkeit des Produktes, wobei Schäden bzw. nicht hinnehmbare Qualitätsminderungen häufig an Komponenten auftreten, die mit dem getauschten Bauteil nicht unmittelbar verbunden sind und somit nicht erwartet wurden.

Hier setzt die Erfindung an. Aufgabe der Erfindung ist es, ein Verfahren der eingangs genannten Art anzugeben, mit welchem eine besonders umfassende Beurteilung von Auswirkungen von Änderungen möglich ist.

Diese Aufgabe wird erfindungsgemäß durch ein Verfahren der eingangs genannten Art gelöst, bei welchem eine Wirkketten-Analyse durchgeführt wird, wobei jeder Komponentengruppe zumindest eine Schadensart zugeordnet wird, welche Schadensart zu einer Funktionsbeeinträchtigung der Komponentengruppe führen kann, wobei jeder Schadensart zumindest eine Betriebsweise zugeordnet wird, welche zum Eintritt der Schadensart führen kann, wobei jeder Betriebsweise zumindest eine messbare Größe zugeordnet wird, durch Messung derselben beurteilbar ist, ob und gegebenenfalls in welcher Intensität die Betriebsweise aktiv ist, sodass durch Messung der Größe während einer Betriebes eine kumulierte Schädigung des Produktes P erfassbar ist, wobei zumindest eine Größe mehr als einer Komponentengruppe zugeordnet ist, wobei anhand der Wirkketten-Analyse eine Auswirkung der Änderung an einer Komponentengruppe auf zumindest eine Größe beurteilt wird, insbesondere mittels einer Simulation, wobei anhand der Auswirkung auf die Größe auf mittelbare Auswirkungen der Änderung auf zumindest eine Schadensart einer weiteren Komponentengruppe geschlossen wird, um eine Auswirkung der Änderung auf eine Qualität, insbesondere eine erwartete Ausfallswahrscheinlichkeit, des Produktes beurteilen zu können.

Im Rahmen der Erfindung wurde erkannt, dass mit Hilfe einer Wirkketten-Analyse, welche im Rahmen einer Produktentwicklung häufig ohnedies durchgeführt wird, um eine Qualität, insbesondere eine Ausfallswahrscheinlichkeit während einer vordefinierten Lebensdauer, eine erwartete Lebenszeit unter vordefinierten angenommenen Betriebsbedingungen oder eine maximale Belastbarkeit, des Produktes zu beurteilen, auch die Auswirkungen von Änderungen auf das gesamte Produkt in einfacher Weise beurteilt werden können. So wird unter Berücksichtigung der Wirkketten-Analyse die Änderung nicht isoliert betrachtet, sondern werden auch Auswirkungen erkennbar, welche an Komponenten bzw. Komponentengruppen auftreten, die der ausgetauschten Komponente bzw. seitdem geänderten Bauteil nicht unmittelbar zugeordnet sind. Somit können Auswirkungen von Änderungen an einer ersten Komponentengruppe bzw. Auswirkungen von Änderungen an einem Bauteil der ersten Komponentengruppe nicht nur auf die erste Komponentengruppe selbst, sondern auch auf die weiteren Komponentengruppen beurteilt werden. Üblicherweise wird das Verfahren bei Produkten umgesetzt, bei welchen Änderungen an zumindest einer Komponentengruppe über zugeordnete Größen Auswirkungen auf zumindest eine Komponentengruppe haben, welche von der Komponentengruppe, an welcher die Änderung vorgenommen wird, verschieden ist.

So kann beispielsweise im Rahmen der Wirkketten-Analyse als relevante Schadensart für einen Kolben eines Motors eine thermische Ermüdung als Schadensart erkannt und der Komponentengruppe Kolben zugeordnet werden. Als zum Eintritt dieser Schadensart beitragende Betriebsweise kann ein dynamischer Betrieb unter Hochlast definiert sein, welcher mittels einer Abgastemperatur erfasst werden kann. Somit kann bei einem Betrieb des Motors durch kontinuierliche Messung der Abgastemperatur eine aktuelle thermische Schädigung bestimmt werden. Wenn eine kumulierte Schädigung eine maximal erträgliche Gesamtschädigung überschreitet, tritt gemäß bekannten Schadensakkumulationsmodellen ein Bauteilversagen, ein Anriss oder eine ähnliche Funktionsbeeinträchtigung auf.

Die Abgastemperatur wirkt jedoch auch als Beitrag zu einer thermischen Schädigung der Sauganlage, welche eine der Komponentengruppe Sauganlage zugeordnete Schadensart ist.

Anhand dieser üblicherweise im Rahmen der Produktentwicklung erstellten Wirkketten-Analyse können nun Auswirkungen einer Änderung, die sich auf die Abgastemperatur auswirkt, einfach bestimmt werden. Beispielsweise wirkt ein Austausch eines gut wärmeleitenden Bauteils in der Sauganlage durch ein schlecht wärmeleitendes Bauteil, indem also beispielsweise ein Bauteil aus Metall durch ein Bauteil aus Kunststoff ersetzt wird, auf eine Abgastemperatur erhöhend, wie sich anhand von Simulationen oder Tests leicht zeigen lässt. Indem die Auswirkung dieser Änderung auf die Abgastemperatur mittels der Wirkketten-Analyse gemäß der Erfindung untersucht wird, werden sämtliche Auswirkungen auf mögliche Schädigungen bzw. Qualitätsverschlechterungen oder Verringerungen der Ausfallswahrscheinlichkeit auch an anderen Komponentengruppen bzw. Bauteilen wie dem Kolben einfach ersichtlich, sodass die durch die Änderung bedingten Auswirkungen auf einfache Weise und gleichzeitig umfassend bestimmt werden können.

Üblicherweise sind einer Komponentengruppe mehrere Schadensarten zugeordnet und sind jeder Schadensart wiederum mehrere Größen zugeordnet. Eine Zuordnung der Schadensarten zu Komponentengruppen bzw. Komponenten kann dabei über eine Belastung der in der Komponentengruppe enthaltenen Komponenten erfolgen. Beispielsweise ergibt sich aus einer Belastung einer Komponente bei Betrieb, welche eine mechanisch wechselnde Beanspruchung enthält, die Schadenart mechanische Ermüdung, wobei die Höhe der mechanischen Beanspruchung beispielsweise über eine Verformung messbar ist, sodass anhand einer kontinuierlichen Messung der Verformung in Verbindung mit Schädigungsmodellen die tatsächliche mechanische Schädigung bestimmbar ist. Analog bedingt eine thermische Belastung eines Bauteils bzw. einer Komponente einer Komponentengruppe im Betrieb die Schadensart thermische Ermüdung der Komponente bzw. der Komponentengruppe, welche wiederum über eine Temperaturmessung in Verbindung mit einem Schädigungsmodell bestimmbar ist. Wirkt auf eine Komponente im Betrieb Reibarbeit als Belastung ein, kann der Komponente die Schadensart abrasiver Verschleiß zugeordnet werden. Nachdem diese Zuordnung häufig ähnlich bzw. bei vielen Bauteilen oder Komponentengruppen vergleichbar ist, kann ein Katalog erstellt werden, in welchem Belastungen im Betrieb bestimmten Schadensarten zugeordnet sind. Mit einem entsprechenden Katalog von Größen, mit welchen die Schadensarten erfassbar sind, kann eine Wirkketten-Analyse auch für komplizierte Produkte auf effiziente Weise erstellt werden. So ist es lediglich erforderlich, die Belastungen im Betrieb zu bestimmen, um zu den Belastungen im Betrieb die entsprechenden Schadensarten und Größen zuzuordnen.

Ein entsprechender Katalog kann beispielsweise für einen Motor oder noch generischer für ein beliebiges mechatronisches Bauteil erstellt werden, sodass eine entsprechende Wirkketten-Analyse für einen weiteren Motor oder ein anderes mechatronisches Bauteil auf einfache Weise erstellt werden kann.

Günstig ist es, wenn sämtliche aus der Wirkketten-Analyse ableitbare Auswirkungen der Änderung auf weitere Komponentengruppe beurteilt werden und anhand von Eintrittswahrscheinlichkeiten der Betriebsweisen, welche zu einem Eintritt der der jeweiligen Komponentengruppe zugeordneten Schadensarten gemäß der Wirkketten-Analyse führen können, eine Erhöhung einer Ausfallswahrscheinlichkeit beurteilt wird. So kann durch eine umfassende Beurteilung sämtlicher Wirkzusammenhänge zwischen den einzelnen Komponenten bzw. Komponentengruppen, die im Rahmen der Wirkketten-Analyse ermittelt wurden, auf einfache Weise eine umfassende Beurteilung der Auswirkung der Änderung auf das gesamte Produkt vorgenommen werden. Beispielsweise kann ein Austausch eines Bauteils sowohl mechanische als auch thermische Auswirkungen haben, welche über unterschiedliche Mechanismen auf verschiedenste Bauteile wirken. Durch Berücksichtigung sämtlicher Auswirkungen kann eine umfassende Beurteilung der Änderung auf eine Reduktion einer Zuverlässigkeit bzw. einer erwarteten Lebensdauer oder einer Qualität des Produktes erfolgen.

Sofern sich zeigt, dass die Änderung zu nicht ohne Weiteres hinnehmbaren Erhöhungen der Ausfallswahrscheinlich oder einer erwarteten Qualitätsverminderung führt, kann wieder unter Zuhilfenahme der Wirkketten-Analyse in einfacher Weise geprüft werden, ob die negativen Auswirkungen durch Maßnahmen reduziert werden können. So kann es günstig sein, wenn aufgrund von ermittelten Auswirkungen Maßnahmen abgeleitet werden, mit welchen negative Auswirkungen der Änderung auf die Ausfallswahrscheinlichkeit des Produktes reduziert werden können. Auf diese Weise können tatsächlich durch den Austausch eines Bauteils erreichbare Kosteneinsparungen wesentlich einfacher transparent gemacht werden, zumal bereits bei Planung der Änderung Kosten für zusätzliche Maßnahmen, die zur Erreichung bzw. Erhaltung einer gewünschten Qualität bzw. einer gewünschten Ausfallssicherheit bei Durchführung der jeweiligen Änderung erforderlich sind, berücksichtigt werden können.

Günstig ist bei einem Verfahren zum Umsetzen einer Änderung an einem Produkt, insbesondere an einem mechatronischen Produkt, welches mehrere, insbesondere zumindest drei, Komponenten aufweist, wenn vor Durchführung der Änderung eine Beurteilung von Auswirkungen gemäß einem erfindungsgemäßen Verfahren durchgeführt wird. Es kann dann vor Umsetzung der Änderung in einfacher Weise beurteilt werden, ob die Auswirkungen der Änderung auf eine Qualität des Produktes tragbar sind bzw. eine geforderte Mindestqualität, insbesondere eine erwartete Lebensdauer oder eine Ausfallswahrscheinlichkeit, erreicht wird. Danach kann die Entscheidung getroffen werden, ob die Änderung in der ursprünglich geplanten Weise, mit Abänderungen oder mit zusätzlichen Maßnahmen umgesetzt wird.

Günstig ist es, wenn die Änderung umgesetzt wird, wenn eine erwartete Qualität bei Umsetzung der Änderung über einer vordefinierten Mindestqualität liegt. Eine Mindestqualität kann beispielsweise eine Belastbarkeit des Produktes sein, welcher das Produkt jedenfalls standhalten muss, eine Lebensdauer, welche das Produkt unter erwarteten Betriebsbedingungen jedenfalls erreichen muss, oder eine Ausfallswahrscheinlichkeit, welche das Produkt unter vordefinierten erwarteten Betriebsbedingungen nicht unterschreiten darf.

Es kann vorgesehen sein, dass zumindest eine Maßnahme umgesetzt wird, um eine Erhöhung der Qualität zu erreichen. Dies ist insbesondere dann vorteilhaft, wenn sich zeigt, dass die erwartete Qualität bei Umsetzung der Änderung zu einer Qualitätsverschlechterung des Produktes führt, welche nicht hinnehmbar wäre. Der Beitrag der Maßnahme zur Qualität kann ebenfalls mit der Wirkketten- Analyse bestimmt werden, gegebenenfalls unter Verwendung von Simulationen und/oder Tests.

Häufig sind mehrere Maßnahmen möglich, die zu einer Qualitätsverbesserung führen können. Es ist dann günstig, wenn die Auswirkungen unterschiedlicher Maßnahmen auf die Qualität des Produktes beurteilt werden und zumindest jene Maßnahme umgesetzt wird, welche einen höchsten Beitrag zur Verbesserung der Qualität liefert. Auch hierzu können die Auswirkungen entsprechender Maßnahmen in einfacher Weise mittels der Wirkketten-Analyse beurteilt werden.

Mit Vorteil ist vorgesehen, dass qualitätsverbessernde Maßnahmen gleichzeitig mit der Änderung umgesetzt werden, wenn die erwartete Qualität ohne gleichzeitige Umsetzung der Maßnahmen unter einer Mindestqualität liegt, wenn die resultierende erwartete Qualität unter Umsetzung der Maßnahmen über der Mindestqualität liegt. Anhand der Wirkketten- Analyse ist somit in einfacher Weise bestimmbar, ob und gegebenenfalls welche Maßnahmen zusätzlich zur Änderung umgesetzt werden müssen, um eine gewünschte Produktqualität zu erreichen, wenn diese alleine mit der Änderung selbst nicht erreichbar zu sein scheint. Ferner kann vorgesehen sein, dass die Änderungen mit den Maßnahmen nur dann umgesetzt werden, wenn die Gesamtkosten unter einer definierten Schwelle bleiben, beispielsweise den Kosten ohne Änderung.

Ein Verfahren nach dem Oberbegriff von Anspruch 1 offenbart die Schrift "A Bayesian Networks Approach to Estimate Engineering Change Propagation Risk and Duration", IEEE Transactions on Engineering Management, von Fatma Nur Yaesin et al. (ISSN: 0018-9391, DOI: 10.1109/TEM.2018.2884242).

Weitere Merkmale, Vorteile und Wirkungen der Erfindung ergeben sich anhand des nachfolgend dargestellten Ausführungsbeispiels. In der Zeichnung, auf welche dabei Bezug genommen wird, zeigt:
Fig. 1 beispielhaft ein Ergebnis einer Wirkketten-Analyse eines Produktes;
Fig. 2 ein Flussdiagramm eines Verfahrens zur Umsetzung einer Änderung.

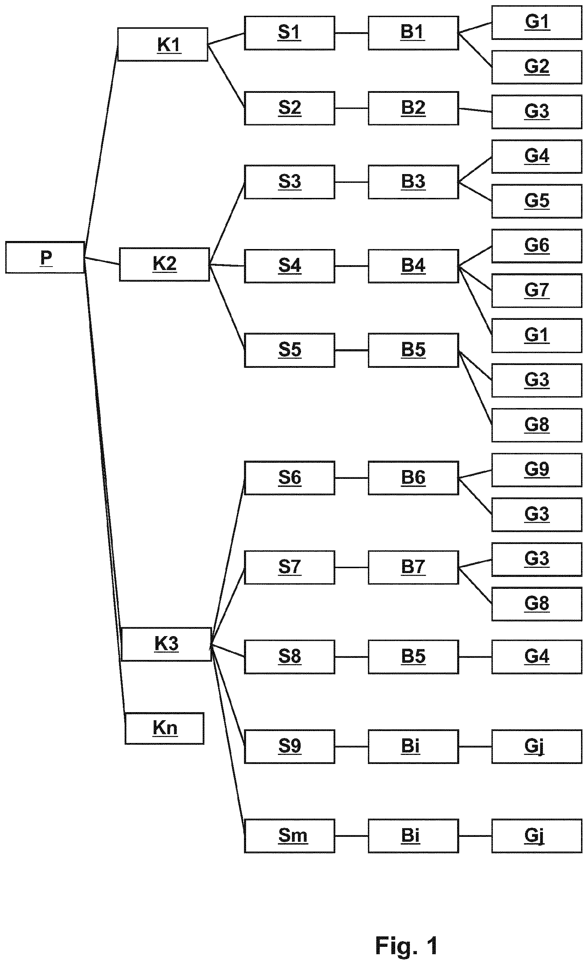

Fig. 1 zeigt ein Ergebnis einer Wirkketten-Analyse eines Produktes P. Das hier beispielshaft als Motor ausgebildete Produkt P wurde im Rahmen der Wirkketten-Analyse gedanklich in die mehrere Komponentengruppen K1, K2, K3, Kn geteilt, wobei eine erste Komponentengruppe K1 den Kolben, eine zweiten Komponentengruppe K2 die Sauganlage und eine dritte Komponentengruppe K3 eine Abgasrückführung betrifft. Darüber hinaus sind weitere Komponentengruppen Kn vorhanden, auf welche hier nicht weiter eingegangen wird. Es versteht sich, dass jede Komponentengruppe K1, K2, K3, Kn eine oder mehreren Komponenten bzw. Bauteile umfassen kann, welche hier nicht gesondert dargestellt sind. Diesen Komponentengruppen K1, K2, K3, Kn wurden jeweils unterschiedliche Schadensarten S1, S2, S3, S4, S5, S6, S7, S8, S9, Sm zugeordnet. Beispielsweise können eine erste Schadensart S1, mechanische Ermüdung des Kolbens, und eine zweite Schadensart S2, thermische Ermüdung des Kolbens, zu einem Schaden am Kolben bzw. der ersten Komponentengruppe K1 führen. Als Schaden wird hier sowohl ein vollständiges Bauteilversagen als auch eine nicht mehr hinnehmbare Qualitätsverschlechterung verstanden.

An für die zweite Komponentengruppe K2, die Sauganlage, relevanten Schadensarten wurden eine dritte Schadensart S3, Korrosion an der Sauganlage, eine vierte Schadensart S4, mechanische Ermüdung der Sauganlage, und eine fünfte Schadensart S5, thermische Ermüdung der Sauganlage, identifiziert.

Als relevante Schadensarten für die dritte Komponentengruppe, die Abgasrückführung, wurden eine sechste Schadensart S6, eine mögliche Leckage, eine siebende Schadensart S7, ein Verzug, eine achte Schadensart S8, Ablagerungen, eine neunte Schadensart S9, thermische Alterung, und weitere Schadensarten Sm, welche hier nicht näher erörtert werden, identifiziert.

Den Schadensarten S1, S2, S3, S4, S5, S6, S7, S8, S9, Sm sind Betriebsweisen B1, B2, B3, B4, B5, B6, B7, Bi zugeordnet, die zum Eintritt der entsprechenden Schadensart S1, S2, S3, S4, S5, S6, S7, S8, S9, Sm führen können.
So sind den Schadensarten S1, S2, S3, S4, S5, S6, S7, S8, S9, Sm die Betriebsweisen B1, B2, B3, B4, B5, B6, B7, Bi wie folgt zugeordnet:
Der ersten Schadensart S1 ist die erste Betriebsweise B1 zugeordnet, wobei der Motor unter Hochlast betrieben wird;
der zweiten Schadensart S2 ist die zweite Betriebsweise B2 zugeordnet, bei welcher der Motor bei Hochlast und dynamischer Belastung betrieben wird;
der dritten Schadensart S3 ist eine dritte Betriebsweise B3 zugeordnet, bei welcher der Motor bei niedriger Außentemperatur betrieben wird;
der vierten Schadensart S4 ist eine vierte Betriebsweise B4 zugeordnet, bei welcher Vibrationen auf den Motor wirken;
der fünften Schadensart S5 ist eine fünfte Betriebsweise B5 zugeordnet, bei welcher der Motor gestartet wird;
der sechsten Schadensart S6 ist eine sechste Betriebsweise B6 zugeordnet, bei welcher der Motor dynamisch beansprucht wird;
der siebenden Schadensart S7 ist eine siebente Betriebsweise B7 zugeordnet, bei welcher der Motor unter Teillast beansprucht wird;
der achten Schadensart S8 ist wieder die fünfte Betriebsweise B5 zugeordnet, bei welcher der Motor gestartet wird.

Auf die der Schadensart S9 und den weiteren Schadensarten Sm zugeordneten Betriebsweisen Bi wird hier nicht näher eingegangen. Unter den weiteren Schadensarten Sm können eine oder mehrere verschiedene Schadensarten und unter den Betriebsweisen Bi eine oder mehrere verschiedene Betriebsweisen verstanden werden.

Den einzelnen Betriebsweisen sind wiederum wie folgt messbaren Größen zugeordnet, mit welchen feststellbar ist, ob die einzelnen Betriebsweisen und gegebenenfalls in welcher Intensität aktiv sind:
Der ersten Betriebsweise B1 sind die erste Größe G1, ein Motormoment, und eine zweite Größe G2, ein Gasdruck im Kolben, zugeordnet;
der zweiten Betriebsweise B2 ist eine dritte Größe G3, die Abgastemperatur, zugeordnet;
der dritten Betriebsweise B3 sind eine vierte Größe G4, eine Temperatur eines Bauteiles, und eine fünfte Größe G5, eine relative Luftfeuchte, zugeordnet;
der vierten Betriebsweise B4 sind eine sechste Größe G6, gemessene Vibrationen eines Fahrzeuges, in welchem der Motor eingebaut ist, eine siebente Größe G7, eine Motordrehzahl, und die erste Größe G1 zugeordnet;
der fünften Betriebsweise B5 sind hier die dritte Größe G3 und eine achte Größe G8, eine AGR-Rate, zugeordnet;
der sechsten Betriebsweise B6 sind hier eine neunte Größe G9 und die dritte Größe G3 zugeordnet;
der siebenten Betriebsweise B7 sind hier die dritte Größe G3 und die achte Größe G8 zugeordnet.

Auf die weiteren Betriebsweisen Bi und den diesen zugeordneten Größen Gj wird hier nicht näher eingegangen. Unter den weiteren Größen Gj können eine oder mehrere verschiedene Größen verstanden werden. Üblicherweise sind einer Komponentengruppe mehrere Schadensarten und einer Schadensart mehrere Größen zugeordnet, weswegen bei einem Produkt P in der Regel eine Anzahl der Größen größer ist als eine Anzahl der Schadensarten, welche wiederum größer ist als eine Anzahl der Komponentengruppen. Anhand der den Betriebsweise zugeordneten Größen kann somit festgestellt werden, ob und gegebenenfalls in welcher Intensität eine Betriebsweise während des Betriebes aktiv ist, sodass mittels einer kontinuierlichen Messung der einzelnen Größen G1, G2, G3, G4, G5, G6, G7, G8, G9, Gj über Schadensakkumulationsmodelle, wie diese beispielsweise nach Miner, Wöhler, Haibach und Palmgren bekannt sind, auf an den Komponentengruppen K1, K2, K3, Kn aufgetretene Schädigungen in den einzelnen Schadensarten S1, S2, S3, S4, S5, S6, S7, S8, S9, Sm schließen zu können. Durch Messung der einzelnen Größen G1, G2, G3, G4, G5, G6, G7, G8, G9, Gj während eines Betriebes des Produktes P ist somit eine Zustandsbeurteilung bzw. die Bestimmung einer Restlebensdauer des Produktes P möglich, sodass ein Eintritt einer Funktionsbeeinträchtigung durch Erreichen eines ertragbaren Schädigungskollektivs vorhersagbar ist.

Wie sich anhand von Fig. 1 somit ergibt können einzelne Größen G1, G2, G3, G4, G5, G6, G7, G8, G9, Gj mehreren Betriebsweisen B1, B2, B3, B4, B5, B6, B7, Bi zugeordnet sein, wie beispielsweise die dritte Größe G3, die Abgastemperatur, der zweiten Betriebsweisen B2, der sechsten Betriebsweise B6 und der siebenten Betriebsweise B7 zugeordnet ist. Weiter können auch einzelne Betriebsweisen B1, B2, B3, B4, B5, B6, B7, Bi mehreren Schadensarten S1, S2, S3, S4, S5, S6, S7, S8, S9, Sm und somit mehreren Komponentengruppen K1, K2, K3, Kn zugeordnet sein, wie hier die fünfte Betriebsweise B5 sowohl der fünften Schadensart S5 als auch der achten Schadensart S8 und somit sowohl der zweiten Komponentengruppe K2 als auch der dritten Komponentengruppe K3 zugeordnet ist.

Bei Beurteilung einer Änderung wird nunmehr gemäß der Erfindung die Wirkketten-Analyse insofern berücksichtigt, als dass beispielsweise bei einem Austausch an einem Element der zweiten Komponentengruppe K2 untersucht wird, welche Auswirkungen dies auf die einzelnen Größen G1, G2, G3, G4, G5, G6, G7, G8, G9, Gj hat. Hier könnte sich beispielsweise der Austausch eines aus Metall bestehenden Bauteiles im Ansaugbereich durch ein günstigeres, aus Kunststoff bestehendes Bauteil, welches schlechtere Wärmeleitfähigkeiten aufweist, auf die dritte Größe G3, die Abgastemperatur, auswirken, wie sich anhand einer Simulation oder eines Versuches ergeben kann. Anhand der Wirkketten-Analyse ergibt sich nun, dass diese dritte Größe G3, die Abgastemperatur, sowohl auf die erste Komponentengruppe K1, als auch die zweite Komponentengruppe K2 und die dritte Komponentengruppe K3 wirkt, sodass anhand von Simulationen bereits vor Umsetzung der Änderung beurteilt werden kann, welche Auswirkungen ein Austausch einer Komponente der zweiten Komponentengruppe K2, der Sauganlage, über eine Produktlebenszeit auf den Kolben und die Abgasrückführung hat. Somit können nicht nur direkte, sondern auch indirekte Auswirkungen einfach bestimmt werden und durch den Austausch bedingte frühere Funktionsbeeinträchtigungen erkannt werden. Weiter werden aus Auswirkungen ersichtlich gemacht, welche erst nach einer längeren Betriebsdauer oder einer Vielzahl von Starts auftreten. Hierzu kann ebenfalls eine numerische Simulation eingesetzt werden. Alternativ oder ergänzend können auch einzelne Versuche durchgeführt werden, die Auswirkungen der Änderung auf das Produkt bzw. eine Ausfallswahrscheinlichkeit der einzelnen Komponentengruppen K1, K2, K3, Kn präzise beurteilen zu können.

Sofern sich dabei zeigt, dass eine erwartete Ausfallswahrscheinlichkeit unter Durchführung der Änderung zu einer nicht hinnehmbaren Verringerung der erwarteten Lebenszeit beispielsweise des Kolbens bzw. des gesamten Motors führt, könnten Maßnahmen gesetzt werden, um die Auswirkungen zu verringern. Die Auswirkungen solcher Maßnahmen können ebenfalls mittels der Wirkketten-Analyse ermittelt werden, sodass leicht ersichtlich ist, ob und gegebenenfalls welche Maßnahmen erforderlich sind, um die gewünschte Qualität oder Ausfallswahrscheinlichkeit des Produktes P auch unter Umsetzung der Änderung zu erreichen. Dadurch können auch die Kosten zur Vermeidung von nicht hinnehmbaren Qualitätsverschlechterungen bereits vor Umsetzung der Änderung bestimmt werden und wird bereits im Rahmen der Planung der Änderung vollständig transparent, welche Gesamtkosten dadurch auflaufen.

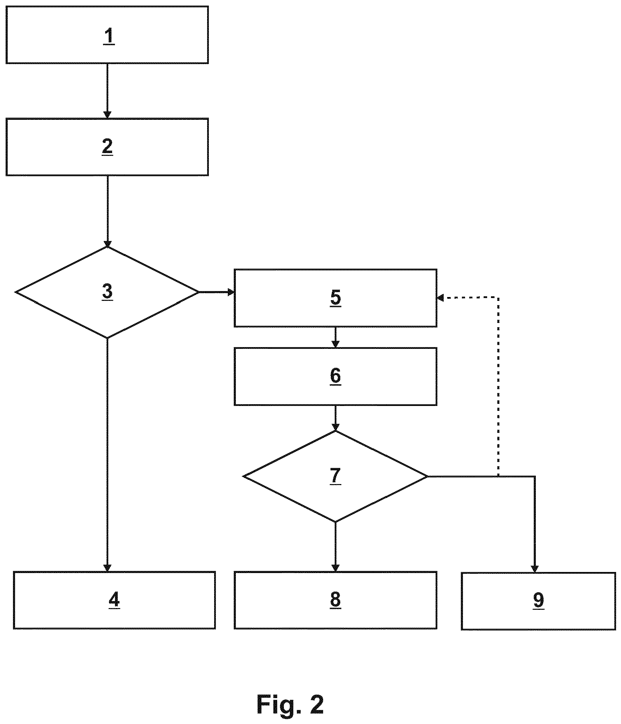

Fig. 2 zeigt ein Flussdiagramm eines Verfahrens zur Umsetzung einer Änderung an einem Produkt P. Zunächst wird in einem ersten Schritt 1 eine Änderung gewählt, welche beispielsweise zu einer Kostenreduktion des Produktes P führen sollte. Dies kann beispielsweise der Austausch eines aus einem teuren Werkstoff bestehenden Bauteils durch ein aus einem günstigeren Werkstoff bestehendes Bauteil sein. In einem zweiten Schritt 2 werden unter Berücksichtigung der Wirkketten-Analyse wie in Fig. 1 dargestellt die Auswirkungen dieser Änderung bestimmt. Hier kann beispielsweise mit Schädigungsmodellen und über eine Lebenszeit des Produktes erwarteten Betriebsweisen sowie deren Häufigkeiten eine erwartete Lebensdauer unter Umsetzung der Änderung berechnet werden. Somit kann eine erwartete Lebensdauer des Produktes P bei Durchführung der Änderung ermittelt werden. In einem dritten Schritt 3 wird geprüft, ob die bei Durchführung der Änderung erreichbare Qualität einer geforderten Mindestqualität genügt. Beispielsweise kann hier geprüft werden, ob die sich aus dem zweiten Schritt 2 ergebende erwartete Lebensdauer der geforderten Mindestlebensdauer genügt oder diese überschreitet. Wird die geforderte Qualität erreicht, wird die Änderung in einem vierten Schritt 4 umgesetzt.

Ergibt die Beurteilung im dritten Schritt 3 jedoch, dass die geforderte Qualität mit der Änderung nicht erreichbar ist, werden in einem fünften Schritt 4 eine oder mehrere Maßnahmen gewählt, welche sich günstig auf die Qualität auswirken sollten. In einem sechsten Schritt 6 wird unter Berücksichtigung der Wirkketten-Analyse wie in Fig. 1 dargestellt die Auswirkung der Änderung unter gleichzeitiger Umsetzung der im fünften Schritt 5 definierten Maßnahmen auf die Qualität, beispielsweise eine erwartete Lebensdauer oder eine maximale Belastbarkeit des Produktes P, analysiert. In einem siebenten Schritt wird wiederum geprüft, ob das Ergebnis aus dem sechsten Schritt 6 der geforderten Qualität zumindest entspricht. Sofern dies der Fall ist, wird das Produkt P mit den im fünften Schritt 5 definierten zusätzlichen Maßnahmen in einem achten Schritt 8 umgesetzt, wobei natürlich auch wirtschaftliche Überlegungen in eine Entscheidung, die Änderung mit den zusätzlichen Maßnahmen umzusetzen, einfließen können. So wird die Umsetzung der Änderung mit den zusätzlichen Maßnahmen üblicherweise nicht umgesetzt, wenn sich dadurch höhere Kosten des Produktes P ergeben. Es können somit weitere, im Flussdiagramm nicht dargestellte Entscheidungen vorgesehen sein.

Sollte sich im siebenten Schritt 7 zeigen, dass die geforderte Qualität, insbesondere eine Lebensdauer, mit den im fünften Schritt 5 definierten zusätzlichen Maßnahmen nicht erreichbar ist, können einerseits weitere Maßnahmen geprüft werden, sodass in einem neuerlichen fünften Schritt 5 weitere Maßnahmen gewählt und die Verfahrensschritte fünf bis sieben mit geänderten Maßnahmen erneut durchlaufen werden können. Andererseits, oder wenn keine weiteren Maßnahmen möglich sind, kann dann i siebenten Schritt 7 entschieden werden, die Änderung nicht umzusetzen, um die geforderte Qualität weiterhin zu erreichen. In diesem Fall führt das Verfahren zu einem neunten Schritt 9, wonach die Änderung nicht umgesetzt wird. Es kann auch vor Umsetzung der Änderung mit einer oder mehreren zusätzlichen Maßnahmen geprüft werden, welche von mehreren möglichen Maßnahmen einen größten Beitrag zu einer Verbesserung der Qualität und/oder einen geringsten Beitrag zu zusätzlichen Kosten verursacht, um eine oder mehrere optimale Maßnahmen zu wählen.

Somit führt das erfindungsgemäße Verfahren auf einfache Weise zur Ermittlung von Auswirkungen von Änderungen. Weiter kann auf einfache Weise verhindert werden, dass Änderungen unerwünschte Auswirkungen auf eine Qualität, insbesondere eine Lebensdauer des Produktes, haben, sodass eine bessere Qualität von Produkten, an welchen Änderungen vorgenommen wurden, erreicht wird.

## Patentansprüche

1. Verfahren zum Umsetzen einer Änderung an einem mechatronischen Produkt P, welches mehrere, insbesondere zumindest drei, Komponenten aufweist, **dadurch gekennzeichnet, dass** vor Durchführung einer Änderung eine Beurteilung von Auswirkungen gemäß einem Verfahren zur Beurteilung von Auswirkungen von zumindest einer Änderung auf ein mehrere Komponentengruppen K1, K2, K3, Kn, welche jeweils eine oder mehrere Komponenten aufweisen, aufweisendes mechatronisches Produkt P, durchgeführt wird, wobei eine Wirkketten-Analyse durchgeführt wird, wobei jeder Komponentengruppe K1, K2, K3, Kn, zumindest eine Schadensart S1, S2, S3, S4, S5, S6, S7, S8, S9, Sm zugeordnet wird, welche Schadensart S1, S2, S3, S4, S5, S6, S7, S8, S9, Sm zu einer Funktionsbeeinträchtigung der Komponentengruppe K1, K2, K3, Kn führen kann, wobei jeder Schadensart S1, S2, S3, S4, S5, S6, S7, S8, S9, Sm zumindest eine Betriebsweise B1, B2, B3, B4, B5, B6, B7, Bi zugeordnet wird, welche zum Eintritt der Schadensart S1, S2, S3, S4, S5, S6, S7, S8, S9, Sm führen kann, wobei jeder Betriebsweise B1, B2, B3, B4, B5, B6, B7, Bi zumindest eine messbare Größe G1, G2, G3, G4, G5, G6, G7, G8, G9, Gj zugeordnet wird, durch Messung derselben beurteilbar ist, ob und gegebenenfalls in welcher Intensität die Betriebsweise B1, B2, B3, B4, B5, B6, B7, Bi aktiv ist, sodass durch Messung der Größe G1, G2, G3, G4, G5, G6, G7, G8, G9, Gj während einer Betriebes eine kumulierte Schädigung des Produktes P erfassbar ist, wobei zumindest eine Größe G1, G2, G3, G4, G5, G6, G7, G8, G9, Gj mehr als einer Komponentengruppe K1, K2, K3, Kn zugeordnet ist, wobei anhand der Wirkketten-Analyse eine Auswirkung der Änderung an einer Komponentengruppe K1, K2, K3, Kn auf zumindest eine Größe G1, G2, G3, G4, G5, G6, G7, G8, G9, Gj beurteilt wird, insbesondere mittels einer Simulation, wobei anhand der Auswirkung auf die Größe auf mittelbare Auswirkungen der Änderung auf zumindest eine Schadensart S1, S2, S3, S4, S5, S6, S7, S8, S9, Sm einer weiteren Komponentengruppe K1, K2, K3, Kn geschlossen wird, um eine Auswirkung der Änderung auf eine Qualität insbesondere eine erwartete Ausfallswahrscheinlichkeit, des Produktes P beurteilen zu können, wobei die Änderung umgesetzt wird, wenn eine erwartete Qualität bei Umsetzung der Änderung über einer vordefinierten Mindestqualität liegt.

2. Verfahren nach Anspruch 1, **dadurch gekennzeichnet, dass** zumindest eine Maßnahme umgesetzt wird, um eine Erhöhung der Qualität zu erreichen, indem die Auswirkungen unterschiedlicher Maßnahmen auf die Qualität des Produktes P beurteilt werden und zumindest jene Maßnahme umgesetzt wird, welche einen höchsten Beitrag zur Verbesserung der Qualität liefert.

3. Verfahren nach den Ansprüchen 1 oder 2, **dadurch gekennzeichnet, dass** qualitätsverbessernde Maßnahmen gleichzeitig mit der Änderung umgesetzt werden, wenn die erwartete Qualität ohne gleichzeitige Umsetzung der Maßnahmen unter einer Mindestqualität liegt und die resultierende erwartete Qualität unter Umsetzung der Maßnahmen über der Mindestqualität liegt.

4. Verfahren nach einem der Ansprüche 1 bis 3, **dadurch gekennzeichnet, dass** sämtliche aus der Wirkketten-Analyse ableitbare Auswirkungen der Änderung auf weitere Komponentengruppen K1, K2, K3, Kn beurteilt werden und anhand von Eintrittswahrscheinlichkeiten der Betriebsweisen B1, B2, B3, B4, B5, B6, B7, Bi, welche zu einem Eintritt der der jeweiligen Komponentengruppe K1, K2, K3, Kn zugeordneten Schadensarten S1, S2, S3, S4, S5, S6, S7, S8, S9, Sm gemäß der Wirkketten-Analyse führen können, eine Erhöhung der Qualität, insbesondere der Ausfallswahrscheinlichkeit, beurteilt wird.

5. Verfahren nach Anspruch 4, **dadurch gekennzeichnet, dass** aufgrund von ermittelten Auswirkungen Maßnahmen abgeleitet werden, mit welchen negative Auswirkungen der Änderung auf die Qualität des Produktes P reduziert werden können.

## Claims

1. Method for implementing a change in a mechatronic product (P), which has multiple, in particular at least three, components, **characterized in that**, prior to the implementation of a change, an evaluation of the effects is carried out according to a method for evaluating the effects of at least one change on a mechatronic product (P) having multiple component groups (K1, K2, K3, Kn), which each have one or more components, wherein an event chain analysis is carried out, wherein at least one type of damage (S1, S2, S3, S4, S5, S6, S7, S8, S9, Sm) is assigned to each component group (K1, K2, K3, Kn), which type of damage (S1, S2, S3, S4, S5, S6, S7, S8, S9, Sm) can lead to a functional impairment of the component group (K1, K2, K3, Kn), wherein at least one operating mode (B1, B2, B3, B4, B5, B6, B7, Bi), which can lead to the occurrence of the type of damage (S1, S2, S3, S4, S5, S6, S7, S8, S9, Sm), is assigned to each type of damage (S1, S2, S3, S4, S5, S6, S7, S8, S9, Sm), wherein at least one measurable variable (G1, G2, G3, G4, G5, G6, G7, G8, G9, Gj) is assigned to each operating mode (B1, B2, B3, B4, B5, B6, B7, Bi), by measuring said variable it can be evaluated whether, and if necessary, at what intensity the operating mode (B1, B2, B3, B4, B5, B6, B7, Bi) is active, such that by measuring the variable (G1, G2, G3, G4, G5, G6, G7, G8, G9, Gj) during operation, a cumulative damage to the product (P) can be detected, wherein at least one variable (G1, G2, G3, G4, G5, G6, G7, G8, G9, Gj) is assigned to more than one component group (K1, K2, K3, Kn), wherein an impact of the change in a component group (K1, K2, K3, Kn) on at least one variable (G1, G2, G3, G4, G5, G6, G7, G8, G9, Gj) is evaluated on the basis of the event chain analysis, in particular by means of a simulation, wherein, on the basis of the impact on the variable, indirect impacts of the change on at least one type of damage (S1, S2, S3, S4, S5, S6, S7, S8, S9, Sm) of a further component group (K1, K2, K3, Kn) are deduced, in order to be able to evaluate an impact of the change on a quality, in particular on an expected probability of failure, of the product (P), wherein the change is implemented if, in the case that the change is implemented, an expected quality lies above a pre-defined minimum quality.

2. Method according to claim 1, **characterized in that** at least one measure is implemented in order to achieve an increase in the quality, **in that** impacts of different measures on the quality of the product (P) are evaluated, and at least that measure is implemented which contributes the most to improving the quality.

3. Method according to claims 1 or 2, **characterized in that** quality-improving measures are implemented simultaneously with the change if the expected quality lies below a minimum quality without the simultaneous implementation of the measures and the resulting expected quality lies above the minimum quality with the implementation of the measures.

4. Method according to one of claims 1 to 3, **characterized in that** all impacts of the change on other component groups (K1, K2, K3, Kn), which can be derived from the event chain analysis, are evaluated and an increase in the quality, in particular the probability of failure, is evaluated on the basis of the probability of occurrence of the operating modes (B1, B2, B3, B4, B5, B6, B7, Bi), which can lead to an occurrence of the types of damage (S1, S2, S3, S4, S5, S6, S7, S8, S9, Sm) assigned to the respective component group (K1, K2, K3, Kn) according to the event chain analysis.

5. The method according to claim 4, **characterized in that** measures are derived based on the determined impacts, with which measures the negative impacts of the change on the quality of the product (P) can be reduced.

## Revendications

1. Procédé, destiné à mettre en application une modification sur un produit mécatronique P, lequel comporte plusieurs, notamment au moins trois composants, **caractérisé en ce qu'**avant de procéder à une modification, il est procédé à une évaluation d'effets selon un procédé d'évaluation des effets d'au moins une modification sur un produit mécatronique P comportant plusieurs groupes de composants K1, K2, K3, Kn, dont chacun comporte un ou plusieurs composants, étant procédé à une analyse de la chaîne de réactions, à chaque groupe de composants K1, K2, K3, Kn étant attribué au moins un type de dommage S1, S2, S3, S4, S5-, S6, S7, S8, S9, Sm, lequel type de dommage S1, S2, S3, S4, S5, S6, S7, S8, S9, Sm étant susceptible d'initier une déficience fonctionnelle du groupe de composants K1, K2, K3, Kn, à chaque type de dommage S1, S2, S3, S4, S5, S6, S7, S8, S9, Sm étant attribué au moins un mode opératoire B1; B2, B3, B4, B5, B6, B7, Bi, lequel est susceptible de faire survenir le type de dommage S1, S2, S3, S4, S5, S6, S7, S8, S9, Sm, à chaque mode opératoire B1, B2, B3, B4, B5, B6, B7, Bi étant attribuée au moins une dimension G1, G2, G3, G4, G5, G6, G7, G8, G9, Gj mesurable, par la mesure de laquelle il est possible d'évaluer si et le cas échéant selon quelle intensité le mode opératoire B1, B2, B3, B4, B5, B6, B7; Bi est actif, de telle sorte que par mesure de la dimension G1, G2, G3, G4, G5, G6, G7, G8, G9, Gj pendant un fonctionnement, une détérioration cumulée du produit P soit détectable, au moins une dimension G1, G2, G3, G4, G5, G6, G7, G8, G9, Gj étant attribuée à plus d'un groupe de composants K1, K2, K3, Kn, à l'aide de l'analyse de la chaîne de réactions, un effet de la modification apportée à un groupe de composants K1, K2, K3, Kn étant évalué à au moins une dimension G1, G2, G3, G4, GS, G6, G7, G8, G9, Gj, notamment au moyen d'une simulation, à l'aide de l'effet sur la dimension étant déduits des effets indirects de la modification sur au moins un type de dommage S1, S2, S3, S4, S5, S6, S7, S8, S9, Sm d'un autre groupe de composants K1, K2, K3, Kn, pour pouvoir évaluer un effet de la modification sur une qualité, notamment une probabilité de défaillance du produit P, la modification étant mise en application si lors de la mise en application de la modification, une qualité attendue est supérieure à une qualité minimale prédéfinie.

2. Procédé selon la revendication 1, **caractérisé en ce qu'**au moins une action visant à obtenir une augmentation de la qualité est mise en application **en ce que** les effets de différentes actions sur la qualité du produit P sont évalués et **en ce qu'**au moins l'action apportant la contribution la plus élevée à l'amélioration de la qualité est mise en application.

3. Procédé selon les revendications 1 ou 2, **caractérisé en ce que** des actions améliorant la qualité sont mises en application simultanément avec la modification si la qualité attendue est inférieure à une qualité minimale en l'absence simultanée de la mise en application des actions et si la qualité attendue résultante est supérieure à la qualité minimale, en cas de mise en application de la modification.

4. Procédé selon l'une quelconque des revendications 1 à 3, **caractérisé en ce que** tous les effets de la modification sur d'autres groupes de composants K1, K2, K3, Kn qui sont déductibles de l'analyse de la chaîne de réactions sont évalués et à l'aide de probabilités de survenance des modes opératoires B1, B2, B3, B4, B5, B6, B7, Bi, lesquels sont susceptibles de faire survenir les types de dommages S1, S2, S3, S4, S5, S6, S7, S8, S9, Sm attribués au groupe de composants K1, K2, K3, Kn concernés selon l'analyse de la chaîne de réactions, une augmentation de la qualité, notamment de la probabilité de défaillance est évaluée.

5. Procédé selon la revendication 4, **caractérisé en ce que** sur la base d'effets déterminés, des actions sont déduites, par lesquelles des effets négatifs de la modification sur la qualité du produit P peuvent être réduites.
